# EUROPEAN PATENT SPECIFICATION

(11) **EP 4 481 402 B1**
(45) Date of publication and mention of the grant of the patent: **18.11.2026**
(21) Application number: 23181069.8
(22) Date of filing: 22.06.2023
(51) Int. Cl.: G01R 1/20, G01R 15/00, G01R 15/09

(54) **CURRENT MEASUREMENT CIRCUIT AND METHOD**
STROMMESSSCHALTUNG UND -VERFAHREN
CIRCUIT ET PROCÉDÉ DE MESURE DE COURANT

(43) Date of publication of application: 25.12.2024
(73) Proprietor: Aptiv Technologies AG, 8200 Schaffhausen (CH)
(72) Inventor: BOUDOUX, Emmanuel, Dublin, 2 (IE); TOKARZ, Krzysztof, Dublin, 2 (IE)
(74) Representative: Lewis Silkin LLP

(56) References cited:
- US-A1- 2015 137 820
- US-A1- 2022 268 811
- US-B1- 7 683 604

## Description

### Introduction

The present disclosure relates to a current measurement circuit and method for controlling a current measurement device. The present disclosure is particularly relevant to a switchable gain amplifier with saturation protection, and current protection devices and load drivers incorporating the same.

### Background

In modern vehicles, it is common to have several loads that consume very high currents. For example, a vehicle's electric power steering (EPS) system may draw up to 80-100 amps in high demand scenarios, such as in urban driving scenarios. In contrast, when the vehicle is travelling at higher speeds in motorway scenarios, the current drawn by the EPS is low because the steering actions are relatively minimal. As vehicles incorporate more automation systems, the range of current demand on load driver circuits continues to increase. For example, a load driver circuit may need to supply current in the range of 1 amp to 800 amps.

The above current ranges present a particular challenge for the current monitoring circuits associated with load drivers. That is, it is typically necessary to incorporate a shunt or current-sense resistor as a current measurement sensor to monitor operation and detect faults in vehicle systems. For example, the current monitoring circuit may be used to trigger an electronic fuse, and hence it is necessary to correctly measure the current to provide for the detection of a potential overcurrent or short-circuit. However, in load drivers capable of supporting very high current, it is necessary to moderate the gain of the current sensor to avoid measurement saturation. However, this reduces the measurement resolution at lower currents.

In load drivers capable of delivering very high currents often use a double driver to avoid exceeding the technical limitations of the MOSFET. In such cases, one configuration to address the above issue is to incorporate dual current measurement, with the outputs of both measurements being combined to measure the overall current. However, although this allows for a lower gain to be achieved on each channel improving overall measurement resolution, component costs are increased as a current amplifier is needed for each channel. Furthermore, the combined measurement requires a microcontroller with several input pins, which adds to the expense and complexity.

Accordingly, there is a need to address the above issues and provide a current measurement circuit having a good measurement resolution for low currents, whilst still being able to monitor for over currents and minimising component costs.

US2022/268811 teaches that controlling a switching element in accordance with a voltage output from a signal amplifying circuit enables adjusting a voltage to be received by a current calculation circuit. Even when a range of air volume to be used is wide and a range of output of a DC motor is wide, or a current flowing through the DC motor has a wide range, a resistance value of a shunt resistor and an amplification factor of a signal amplifying circuit are not required to be reduced, and thus current detection accuracy of the DC motor can be improved.

US7683604 teaches an integrated circuit current shunt amplifier which includes an amplifier having a (+) input connected to a first terminal of a shunt resistor. An output transistor has a gate coupled to an output of the amplifier, a source coupled to a (-) input of the amplifier, and a drain coupled to a first terminal of an output resistor. A gain resistor is coupled between the (-) input of the amplifier and a second terminal of the shunt resistor. The gain resistor has a temperature coefficient which is essentially the same as that of the shunt resistor. A voltage regulator can be coupled between the second terminal of the shunt resistor and a low-side supply voltage terminal of the amplifier. A charge pump can provide a below-ground voltage on a second terminal of the output resistor. A difference amplifier (31) coupled to the drain and referenced to the below-ground voltage produces an output voltage referenced to ground.

US 2015/137820 discloses a circuit which comprises a battery field-effect transistor (FET) coupled between a battery and an electronic system so that current from the battery flows through the battery FET to the electronic system. A replica FET couples the battery to a current sensing circuit. One of the battery FET and the replica FET comprises a plurality of parallel FET segments having separate control terminals. A logic block provides a plurality of switch control signals based on a system state input. A switching circuit receives the switch control signals and selectively couples the separate control terminals of the FET segments to one of a first reference voltage terminal or a second reference voltage terminal to independently turn each FET segment on or off. The current sensing circuit provides a voltage indicative of the current flowing through the replica FET.

### Summary

According to a first arrangement, there is provided a current measurement circuit comprising: an operational amplifier comprising two inputs and an output; an input connector for connecting the two inputs across a current-sense resistor; a gain control sub-circuit connected to the output, wherein the gain control sub-circuit comprises a switch operable to select a current path from a plurality of current paths; and a measurement output connected to the gain control sub-circuit for outputting a signal indicating the measured current based on the selected current path, the gain control subcircuit is configured to select the gain across the operational amplifier wherein the measurement output comprises a high gain measurement output and a low gain measurement output, and the gain control sub-circuit comprises first and second output resistors connected in series, and the switch is operable select a low gain current path for providing a lower gain signal on the low gain measurement output by bypassing the first output resistor and connecting to ground through the second output resistor, and where in the switch is operable to select a high gain current path for providing a higher gain signal on the high gain measurement output by connecting to ground through the first and second output resistors.

In this way, a switchable gain amplifier may be provided which allows for saturation protection by selectively varying its gain. As such, high resolution current measurements may be achieved at low current levels by selecting a higher gain configuration, while higher currents can be accommodated without saturation of the signal by selecting a lower gain configuration.

In some forms, the current measurement circuit further comprises a controller for controlling the switch based on characteristics indicative of the sensed current amplitude. In this way, the controller may automatically vary the gain of the measurement circuit to optimise the resolution against the risk of measurement saturation.

In some forms, the controller controls the switch based on the characteristics exceeding a threshold, and wherein the threshold is selected to be indicative of a current amplitude below a saturation amplitude associated with the operational amplifier. In this way, the risk of measurement saturation may be avoided by selecting a threshold lower than a current amplitude level at which the measurements will saturate.

In some forms, the characteristics comprise the voltage.

In some forms, the voltage on the output is measured relative to ground.

In some forms, the controller comprises a comparator for comparing a voltage on the measurement output to a threshold. In this way, a rapid response may be provided by the controller.

In some forms, the controller further comprises a voltage follower connected between the measurement output and the comparator for generating an input signal to the comparator based on a voltage on the measurement output. In this way, the voltage follower may function as an input buffer to avoid influence of the comparator on the measured signal.

According to a second arrangement, there is provided a load driver comprising the current measurement circuit according to any of the above.

According to a third arrangement, there is provided a current protection device comprising the current measurement circuit to any of the above.

According to a fourth arrangement, there is provided a method of controlling the current measurement circuit according to any of the above, comprising: identifying characteristics exceeding a threshold, wherein the threshold is selected to be indicative of a current amplitude below a saturation amplitude associated with the operational amplifier; controlling the switch to select a current path for reducing the gain across the operational amplifier.

In embodiments, the controller further comprises a hysteresis for preventing oscillations of the comparator output. As such, the threshold may be complemented by a hysteresis, such as a feedback resistor from the output to the positive input below the comparator. This may thereby avoid oscillations of the output of the comparator in which there is successive quick tuning-on and -off of the switch when there is a low amplitude oscillation of the measured current around the threshold value.

### Brief Description of Drawings

Illustrative arrangements will now be described with reference to the accompanying drawings in which:
Figure 1 shows a current measurement circuit according to a first example arrangement;
Figure 2 shows a current measurement circuit according to a second example arrangement;
Figure 3 shows an alternative representation of the current measurement circuit 1 shown in Figure 2;
Figure 4 shows a current measurement circuit according to a fourth example arrangement; and
Figure 5 shows a current measurement circuit according to a fifth example arrangement.

### Detailed Description

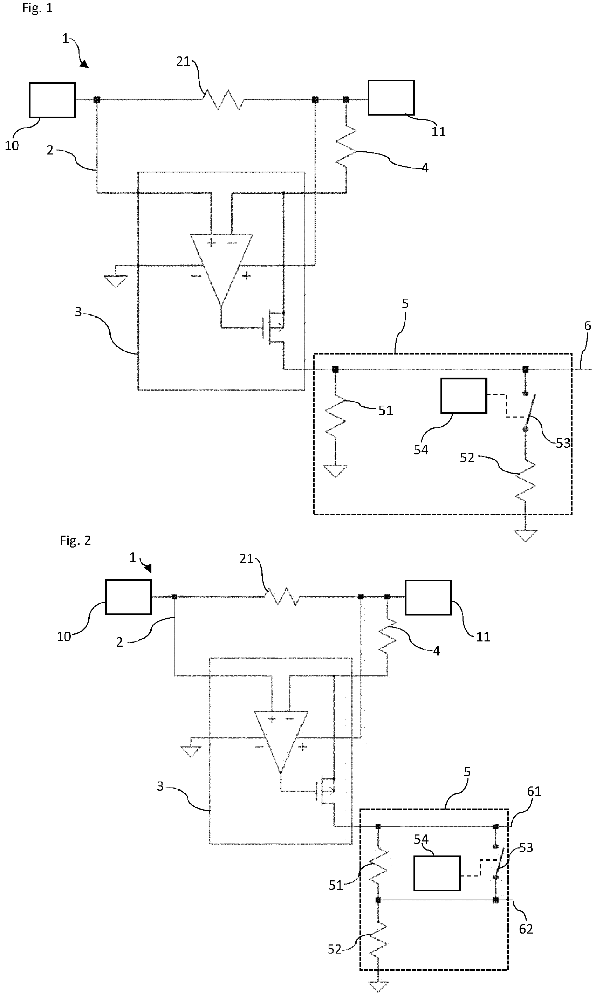

Figure 1 shows a current measurement circuit 1 according to a first example arrangement. The circuit 1 comprises a shunt resistor 21 connected on the line between a power supply 11, such as a battery, and a load 10. A bypass 2 is connected around the shunt resistor 21 and functions as an input for connecting to an operational amplifier (op-amp) 3 in a differential amplifier configuration. An input resistor 4 is connected on the line to the inverting input of the op-amp 3.

A gain control sub-circuit 5 is connected to the output line 6 from the op-amp 3. The gain control circuit 5 comprises a first output resistor 51 connecting between the output line 9 and ground, and a parallel second output resistor 52 switchably connecting between the output line 6 and ground. The second output resistor 52 is switchably connected under the control of switch 53. As such, the operation of switch 53 controls the gain of the current sense circuit based on varying the resistance of the gain control sub-circuit 5.

In this connection, switch 53 may be implemented as a MOSFET controllable to adjust the gain of the current measurement circuit 1 based on the combination of gain setting resistors used. That is, the overall gain is equal to the resistance provided by the gain control sub-circuit 5 divided by the resistance provided by the input resistor 4. As such, when switch 53 is closed, the second output resistor 52 is connected, lowering the resistance of the gain control sub-circuit 5. As such, the gain is reduced. This allows higher currents to be measured without saturation. Conversely, when switch 53 is open, thereby disconnecting the second output resistor 52, the output resistance is increased, providing an increased gain. This allows lower currents to be measured with a higher resolution.

The switch 53 is controlled by a controller 54. The controller 54 may be implemented using, for example, a microcontroller or a comparator which provides a signal for controlling the switch 53 such that the switch 53 is open when the voltage being measured exceeds a threshold and closed when the voltage being measured is below the threshold. Accordingly, at higher currents, where a voltage exceeds a predetermined threshold, the gain control subcircuit 5 is set to a lower gain to avoid saturation. Conversely, at lower currents, where the voltage is below the predetermined threshold, the gain control sub-circuit 5 is set to a higher gain for improved resolution.

Figure 2 shows a current measurement circuit 1 according to a second example arrangement. This arrangement is similar to the first example, except that gain control sub-circuit 5 comprises the first and second output resistors 51 and 52 connected in series between the output line of the op-amp 3 and ground, with the output line 6 being divided into a high-gain measurement output line 61 and low-gain measurement output line 62. Again, the operation of switch 53 is used to control the gain of the current sense circuit 1 based on varying the resistance of the gain control subcircuit 5.

In this connection, with the switch 53 open, the output resistance of the gain control sub-circuit 5 is the sum of the first and second output resistors 51,52, resulting in a high-gain output on high-gain measurement output line 61. As such, the high-gain measurement output line 61 provides a high gain output which can be used for measuring low currents. However, as the current increases, saturation will occur. To address this, switch 53 may be closed to thereby bypass the first output resistor 51. As such, the gain is based on the resistance of the second output resistor 52 divided by the input resistor 4, resulting in a low-gain output being applied on low-gain measurement output line 62. Accordingly, the closing of switch 53 acts to disable the high gain, low current measurement chain outputted on high-gain measurement output line 61.

The switch 53 in this second example is similarly controlled by a controller 54, as with the first example. Accordingly, when the voltage being measured is below a threshold, the switch 53 is closed, providing for a higher gain. Conversely, when the voltage exceeds a predetermined threshold, the switch 53 is opened, providing for a lower gain, for thereby avoiding saturation.

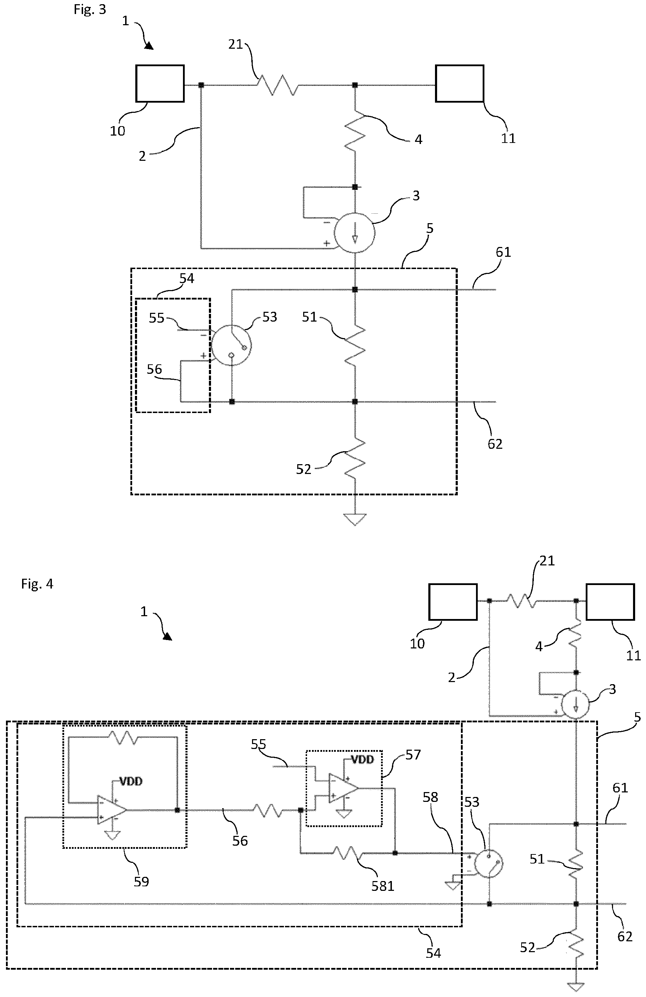

Figure 3 shows an alternative representation of the current measurement circuit 1 shown in Figure 2, with corresponding features numbered the same. In this case, the controller 54 operates by comparing a threshold voltage input 55 to controller input 56 taken from the low-gain measurement output line 62. As such, when the voltage on the controller input 56 exceeds the threshold voltage applied to threshold voltage input 55, the switch 53 is opened to provide for a lower gain in the current measurement circuit. The low-gain measurement output line 62 is used for the voltage measurement because this is used for high current measurements and the gain on this line is stable and hence is not affected by gain changes implemented using switch 53.

Figure 4 shows a current measurement circuit 1 according to a third example arrangement. This arrangement is similar to the circuit shown in Figure 3, except that the controller 54 is shown in further detail. In this case, the signal applied to switch input 58 is controlled by a comparator 57, which includes an op-amp with positive feedback for comparing the voltage on input line 56 with a voltage on threshold voltage input 55. The input line 56 is connected to a voltage follower 58 which simply follows the voltage on the low-gain measurement output line 62, but acts to prevent the comparator 57 from disturbing the signal on the low-gain measurement output line 62. In particular, the provision of a voltage follower 58 may act to mitigate the influence of temperature changes on the switching threshold of the controller 54.

In addition, the controller 54 in this arrangement also incorporates a hysteresis around the comparison threshold to avoid oscillations. That is, the threshold set by the input 55 of comparator 57 is complemented by a feedback resistor 581 from the output 58 to the positive input below comparator 57. This thereby provides a hysteresis which acts to avoid oscillations of the output 58 of the comparator 57 and thereby avoids the successive quick tuning-on and -off of the switch 53 in scenarios where there is a low amplitude oscillation of the measured current around the threshold value.

Accordingly, with the above arrangement, the comparator 57 generates a switch command signal on the switch input 58 when the voltage exceeds a predetermined threshold in order to open the switch 53 for providing a lower gain. As such, saturation of the measurement signal may be avoided.

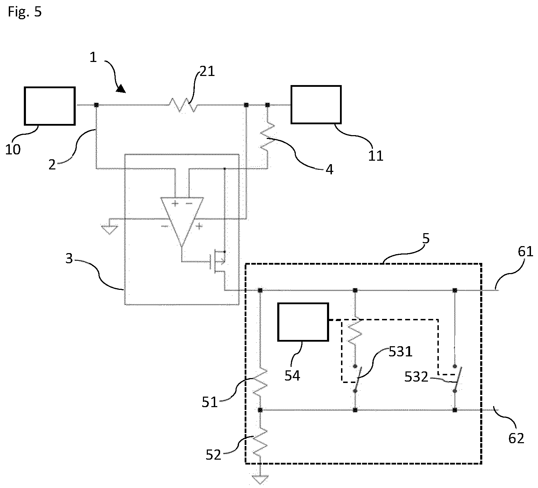

It will be understood that current measurement circuits may be implemented to provide more than two gains. In this respect, Figure 5 shows a current measurement circuit 1 according to a fourth example arrangement. In this case, the gain control sub-circuit 5 comprises two gain control switches 531,532 which are independently controlled by controller 54 in order to vary the output resistance. This provides additional gain levels which can be used to vary the amplification of the current measurement circuit.

Accordingly, with the above arrangements, a variable gain current measurement amplifier may be provided which allows for current to be accurately measured over a wide range of amplitudes. In particular, saturation of the measurement amplifier can be avoided at high currents, whilst still providing for high resolution at lower currents.

It will be understood that the embodiments illustrated above show applications only for the purposes of illustration. In practice, embodiments may be applied to many different configurations, the detail of which being straightforward for those skilled in the art to implement.

For example, a microcontroller may be used to monitor the measurement chain and control the switching of the gain control sub-circuit. However, the measurement circuit can go into saturation between two polling periods of the microcontroller if the current varies abruptly. As such, controlling the gain change using a comparator allows rapid gain switching based on logic functions.

It will also be understood that in some arrangements, the low gain (high current) measurement line may be monitored continually, by providing a dedicated low-gain measurement output line 62 with the two output resistors in series.

Finally, it will be understood that various arrangements may be implemented to incorporate the hysteresis principle described above in relation to Figure 4. As such, the controller may be reinforced using a hysteresis around the comparison threshold in order to avoid oscillations. In arrangements, this hysteresis may be implemented on an analogue comparator with a feedback of the output to the positive input, or digitally in a microcontroller by adjusting the threshold accordingly once a crossing of the initial threshold has been detected.

## Claims

1. A current measurement circuit (1) comprising:
an operational amplifier (3) comprising two inputs and an output;
an input connector for connecting the two inputs across a current-sense resistor (21);
a gain control sub-circuit (5) connected to the output, wherein the gain control sub-circuit comprises a switch (53) operable to select a current path from a plurality of current paths;
a measurement output (61,62) connected to the gain control sub-circuit (5) for outputting a signal indicating the measured current based on the selected current path,
wherein the gain control sub-circuit (5) is configured to select the gain across the operational amplifier (3) ;
wherein the measurement output comprises a high gain measurement output (61) and a low gain measurement output (62), and the gain control sub-circuit comprises first and second output resistors (51,52) connected in series, and the switch is operable select a low gain current path for providing a lower gain signal on the low gain measurement output (62) by bypassing the first output resistor (51) and connecting to ground through the second output resistor (52), and where in the switch is operable to select a high gain current path for providing a higher gain signal on the high gain measurement output (61) by connecting to ground through the first (51) and second output (52) resistors.

2. A current measurement circuit (1)_according to claim 1,
wherein the input connector comprises an input resistor (4).

3. A current measurement circuit (1) according to any preceding claim, further comprising a controller (54) for controlling the switch (53) based on characteristics indicative of the sensed current amplitude.

4. A current measurement circuit (1) according to claim 3, wherein the controller (54) controls the switch (53) based on the characteristics exceeding a threshold, and wherein the threshold is selected to be indicative of a current amplitude below a saturation amplitude associated with the operational amplifier (3).

5. A current measurement circuit according to claim 3 or 4, wherein the characteristics comprise the voltage.

6. A current measurement circuit (1) according to claim 5, wherein the voltage is measured relative to ground.

7. A current measurement circuit (1) according to any one of claims 3-6, wherein the controller (54) comprises a comparator (57) for comparing a voltage on the measurement output to a threshold.

8. A current measurement circuit (1) according to claim 7, wherein the controller (54) further comprises a voltage follower (59) connected between the measurement output (62) and the comparator (57) for generating an input signal to the comparator (57) based on a voltage on the measurement output (62).

9. A current measurement circuit (1) according to claim 7 or 8, wherein the controller (54) further comprises a hysteresis for preventing oscillations of the comparator output (57).

10. A load driver comprising the current measurement circuit (1) according to any preceding claim.

11. A current protection device comprising the current measurement circuit (1) according to any of claims 1-9.

12. A method of controlling the current measurement circuit (1) according to any of claims 1-9, comprising:
identifying characteristics exceeding a threshold, wherein the threshold is selected to be indicative of a current amplitude below a saturation amplitude associated with the operational amplifier (3);
controlling the switch (53) to select a current path for reducing the gain across the operational amplifier (3).

## Patentansprüche

1. Strommessschaltung (1) umfassend:
einen Operationsverstärker (3) mit zwei Eingängen und einem Ausgang;
einen Eingangsanschluss zum Verbinden der beiden Eingänge über einen Strommesswiderstand (21);
eine mit dem Ausgang verbundene Verstärkungsregelungs-Teilschaltung (5), wobei die Verstärkungsregelungs-Teilschaltung einen Schalter (53) umfasst, der so betätigbar ist, dass er einen Strompfad aus einer Vielzahl von Strompfaden auswählt;
einen mit der Verstärkungsregelungs-Teilschaltung (5) verbundenen Messausgang (61, 62) zum Ausgeben eines Signals, das den gemessenen Strom basierend auf dem ausgewählten Strompfad angibt;
wobei die Verstärkungsregelungs-Teilschaltung (5) so konfiguriert ist, dass sie die Verstärkung über den Operationsverstärker (3) auswählt;
wobei der Messausgang einen Messausgang (61) mit hoher Verstärkung und einen Messausgang (62) mit niedriger Verstärkung umfasst und die Verstärkungsregelungs-Teilschaltung einen ersten und einen zweiten Ausgangswiderstand (51, 52) umfasst, die in Reihe geschaltet sind, und wobei der Schalter betätigbar ist, einen Strompfad mit niedriger Verstärkung auszuwählen, um ein Signal mit niedrigerer Verstärkung an dem Messausgang (62) mit niedriger Verstärkung bereitzustellen, indem der erste Ausgangswiderstand (51) überbrückt und eine Verbindung über den zweiten Ausgangswiderstand (52) mit Masse hergestellt wird, und wobei der Schalter betätigbar ist, einen Strompfad mit hoher Verstärkung auszuwählen, um ein Signal mit höherer Verstärkung an dem Messausgang (61) mit hoher Verstärkung bereitzustellen, indem über den ersten Ausgangswiderstand (51) und den zweiten Ausgangswiderstand (52) eine Verbindung mit Masse hergestellt wird.

2. Strommessschaltung (1) nach Anspruch 1, wobei der Eingangsanschluss einen Eingangswiderstand (4) umfasst.

3. Strommessschaltung (1) nach einem der vorhergehenden Ansprüche, ferner umfassend eine Steuerung (54) für das Regeln des Schalters (53) basierend auf Merkmalen, die die Amplitude des erfassten Stroms angeben.

4. Strommessschaltung (1) nach Anspruch 3, wobei die Steuerung (54) den Schalter (53) basierend darauf regelt, dass die Merkmale einen Schwellenwert überschreiten, und wobei der Schwellenwert so gewählt ist, dass er eine Stromamplitude unterhalb einer mit dem Operationsverstärker (3) verbundenen Sättigungsamplitude angibt.

5. Strommessschaltung nach Anspruch 3 oder 4, wobei die Merkmale die Spannung umfassen.

6. Strommessschaltung (1) nach Anspruch 5, wobei die Spannung relativ zur Masse gemessen wird.

7. Strommessschaltung (1) nach einem der Ansprüche 3 bis 6, wobei die Steuerung (54) einen Komparator (57) zum Vergleichen einer Spannung an dem Messausgang mit einem Schwellenwert umfasst.

8. Strommessschaltung (1) nach Anspruch 7, wobei die Steuerung (54) ferner einen Spannungsfolger (59) umfasst, der zwischen dem Messausgang (62) und dem Komparator (57) verbunden ist, um ein Eingangssignal für den Komparator (57) basierend auf einer Spannung am Messausgang (62) zu erzeugen.

9. Strommessschaltung (1) nach Anspruch 7 oder 8, wobei die Steuerung (54) ferner eine Hysterese zum Verhindern von Schwingungen des Komparatorausgangs (57) umfasst.

10. Lasttreiber, umfassend die Strommessschaltung (1) nach einem der vorhergehenden Ansprüche.

11. Stromschutzvorrichtung, umfassend die Strommessschaltung (1) nach einem der Ansprüche 1 bis 9.

12. Verfahren zum Regeln der Strommessschaltung (1) nach einem der Ansprüche 1 bis 9, umfassend:
Identifizieren von Merkmalen, die einen Schwellenwert überschreiten, wobei der Schwellenwert so ausgewählt ist, dass er eine Stromamplitude unterhalb einer dem Operationsverstärker (3) zugeordneten Sättigungsamplitude angibt;
Regeln des Schalters (53) zum Auswählen eines Strompfads zum Verringern der Verstärkung des Operationsverstärkers (3).

## Revendications

1. Circuit de mesure de courant (1) comprenant :
un amplificateur opérationnel (3) comprenant deux entrées et une sortie ;
un connecteur d'entrée destiné à connecter les deux entrées à travers une résistance de détection de courant (21) ;
un sous-circuit de commande de gain (5) connecté à la sortie, dans lequel le sous-circuit de commande de gain comprend un commutateur (53) utilisable pour sélectionner un trajet de courant parmi une pluralité de trajets de courant ;
une sortie de mesure (61, 62) connectée au sous-circuit de commande de gain (5) destinée à émettre en sortie un signal indiquant le courant mesuré en fonction du trajet de courant sélectionné,
dans lequel le sous-circuit de commande de gain (5) est conçu pour sélectionner le gain à travers l'amplificateur opérationnel (3) ;
dans lequel la sortie de mesure comprend une sortie de mesure à gain élevé (61) et une sortie de mesure à gain faible (62), et le sous-circuit de commande de gain comprend une première et seconde résistances de sortie (51, 52) connectées en série, et le commutateur peut être actionné pour sélectionner un trajet de courant à gain faible destiné à fournir un signal de gain plus faible sur la sortie de mesure à gain faible (62) en contournant la première résistance de sortie (51) et en se connectant à la masse au moyen de la seconde résistance de sortie (52), et dans lequel le commutateur est utilisable pour sélectionner un trajet de courant à gain élevé destiné à fournir un signal de gain plus élevé sur la sortie de mesure à gain élevé (61) en se connectant à la masse au moyen des première (51) et seconde (52) résistances de sortie.

2. Circuit de mesure de courant (1) selon la revendication 1, dans lequel le connecteur d'entrée comprend une résistance d'entrée (4).

3. Circuit de mesure de courant (1) selon une quelconque revendication précédente, comprenant en outre un dispositif de commande (54) destiné à commander le commutateur (53) en fonction des caractéristiques indiquant l'amplitude de courant détectée.

4. Circuit de mesure de courant (1) selon la revendication 3, dans lequel le dispositif de commande (54) commande le commutateur (53) en fonction des caractéristiques dépassant un seuil, et dans lequel le seuil est sélectionné pour indiquer une amplitude de courant inférieure à une amplitude de saturation associée à l'amplificateur opérationnel (3).

5. Circuit de mesure de courant selon la revendication 3 ou 4, dans lequel les caractéristiques comprennent la tension.

6. Circuit de mesure de courant (1) selon la revendication 5, dans lequel la tension est mesurée par rapport à la masse.

7. Circuit de mesure de courant (1) selon l'une quelconque des revendications 3 à 6, dans lequel le dispositif de commande (54) comprend un comparateur (57) destiné à comparer une tension sur la sortie de mesure à un seuil.

8. Circuit de mesure de courant (1) selon la revendication 7, dans lequel le dispositif de commande (54) comprend en outre un suiveur de tension (59) connecté entre la sortie de mesure (62) et le comparateur (57) destiné à générer un signal d'entrée vers le comparateur (57) en fonction d'une tension sur la sortie de mesure (62).

9. Circuit de mesure de courant (1) selon la revendication 7 ou 8, dans lequel le dispositif de commande (54) comprend en outre une hystérésis destinée à empêcher les oscillations de la sortie de comparateur (57).

10. Circuit d'attaque de charge comprenant le circuit de mesure de courant (1) selon une quelconque revendication précédente.

11. Dispositif de protection de courant comprenant le circuit de mesure de courant (1) selon l'une quelconque des revendications 1 à 9.

12. Procédé de commande d'un circuit de mesure de courant (1) selon l'une quelconque des revendications 1 à 9, comprenant :
l'identification des caractéristiques dépassant un seuil, dans lequel le seuil est sélectionné pour indiquer une amplitude de courant inférieure à une amplitude de saturation associée à l'amplificateur opérationnel (3) ;
la commande du commutateur (53) pour sélectionner un trajet de courant destiné à réduire le gain à travers l'amplificateur opérationnel (3).
